(19) Europäisches Patentamt
European Patent Office
Office européen des brevets

(11) **EP 4 343 504 B1**

(12) **EUROPEAN PATENT SPECIFICATION**

(45) Date of publication and mention
of the grant of the patent:
**25.02.2026 Bulletin 2026/09**

(21) Application number: **22803876.6**

(22) Date of filing: **13.05.2022**

(51) International Patent Classification (IPC):
**G06F 3/041** (2006.01)    **G02F 1/1333** (2006.01)

(52) Cooperative Patent Classification (CPC):
**H10K 59/40; G02F 1/13338; G02F 1/136286;
H10K 59/131;** G06F 2203/04105

(86) International application number:
**PCT/CN2022/092650**

(87) International publication number:
**WO 2022/242554 (24.11.2022 Gazette 2022/47)**

(54) **DISPLAY ASSEMBLY AND ELECTRONIC DEVICE**

ANZEIGEANORDNUNG UND ELEKTRONISCHE VORRICHTUNG

ENSEMBLE D'AFFICHAGE ET DISPOSITIF ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.05.2021 CN 202110542639**

(43) Date of publication of application:
**27.03.2024 Bulletin 2024/13**

(73) Proprietor: **Vivo Mobile Communication Co., Ltd.
Dongguan, Guangdong 523863 (CN)**

(72) Inventors:
• **JIA, Guangqi
Dongguan, Guangdong 523863 (CN)**

• **WANG, Le
Dongguan, Guangdong 523863 (CN)**

(74) Representative: **Conti, Marco
Bugnion S.p.A.
Via di Corticella, 87
40128 Bologna (IT)**

(56) References cited:
**EP-A1- 3 327 556       EP-A2- 0 706 147
EP-A2- 2 267 791       CN-A- 102 236 447
CN-A- 106 644 194     CN-A- 107 340 929
CN-A- 113 311 959     JP-A- 2013 077 305
US-A1- 2019 121 484   US-B1- 9 880 676**

## Description

## TECHNICAL FIELD

This application belongs to the technical field of electronic devices, and in particular, relates to a display module and an electronic device.

## BACKGROUND

With continuous development of terminal devices, advantages of pressure-sensitive buttons become increasingly obvious, as physical buttons are not needed. In some instances, a pressure-sensitive button is mainly used pressure sensing on bezels to implement a corresponding function, to satisfy a specific requirement for human-machine interaction.

However, as there are increasingly more functional requirements on a screen for interaction of a whole machine, an idea of combining a pressure-sensitive button and a screen has emerged. Because a pressure-sensitive module set for pressure-sensitive buttons is stacked up in a direction perpendicular to a screen, a whole electronic device is thick, and user experience is impacted.

CN107340929A discloses a a pressure-sensitive touch display panel and a display device. The pressure-sensitive touch display panel includes a substrate and a pressure sensing unit; the pressure sensing unit comprises a pressure-sensitive electrode and a pressure-sensitive signal line electrically connected to the electrode. By positioning the first metal layer containing the pressure-sensitive signal line between the substrate and the pressure-sensitive electrode's first semiconductor layer, the pressure sensing unit can be formed in the inter-pixel spacing area, thereby reducing its impact on the aperture ratio.

EP3327556A1 discloses a display apparatus includes a display panel and a window member. The display panel includes pixels configured to display an image. The window member is disposed on the display panel. The window member includes a window substrate, polarization patterns, first electrodes, and second electrodes. The window substrate includes a first surface and a second surface. The first surface includes a first groove defined therein. The second surface faces the first surface. The second surface includes a second groove defined therein.

EP0706147A2 provides for the cancellation of electrostatic noise in a digitizing tablet having a shield supplying a signal proportional to the electrostatic noise which is subtracted from the information signal derived from a digitizing grid. A conductive transparent shield is interposed between a digitizing grid and image source so that the same electrostatic noise appears on both.

EP2267791A2 relates to a touch sensing apparatus. The touch sensing apparatus of the present invention includes a first sensing electrode arranged on a rear surface of a window to sense the touch of a user on the window covering a display screen, a second sensing electrode superimposed onto the first sensing electrode with an insulating layer interposed therebetween, and a buffer for transmitting voltage of the first sensing electrode side to the second sensing electrode side. The touch sensing apparatus of the present invention is capable of effectively cutting off noise signals generated from a display module and keeping touch sensitivity at a high level.

US9880676B1 discloses electronic devices including force sensitive sensors. The sensor may include a first layer of electrodes, a second layer of electrodes and a deformable dielectric material separating the first layer of electrodes and the second layer of electrodes. A conductive material may be disposed to negate capacitive effects between an object near to or touching the touch surface and the electrodes of the first layer and the electrodes of the second layer. A force applied to the sensor may be detected based at least in part on a change in capacitance between at least one electrode of the first layer and at least one electrode of the second layer resulting from deformation of the deformable dielectric material.

US2019121484A1 provides a display panel, a display device and a force touch method thereof. The display panel includes a plurality of force sensors disposed in a display area and a touch electrode including a plurality of touch electrode blocks. Each of the plurality of force sensors includes four force electrodes sequentially interconnected end-to-end, which are a first force electrode, a second force electrode, a third force electrode and a fourth force electrode. One or more of the plurality of touch electrode blocks each are frame-shaped electrodes and each of the plurality of force sensors corresponds to a respective one of the frame-shaped electrodes. Each of the frame-shaped electrodes is provided with a hollow area, and each of the plurality of force sensors is disposed in the hollow area of the respective frame-shaped electrode thereof.

CN102236447A discloses a display and piezoelectric elements inside an insulating layer. Wiring layers are provided on top and bottom of the insulating layer having the piezoelectric elements buried in the latter.

## SUMMARY

Embodiments of this application provide a display module and an electronic device, and can solve a problem that a whole electronic device is thick because an existing pressure-sensitive module set is stacked up in a direction perpendicular to a screen. The invention is reflected in the independent claim.

To resolve the technical problem, this application is implemented as follows:

According to a first aspect, a display module is provided. The display module includes a display screen, a metal conducting layer, and an insulation protection layer. The display screen, the metal conducting layer, and the insulation protection layer are superposed sequentially.

The insulation protection layer includes at least one via, a side, of the insulation protection layer, facing away from the metal conducting layer is disposed with at least one deformable member, and the deformable member is electrically connected to the metal conducting layer through the via.

When pressure is put on the display screen, the deformable member is deformed and outputs an electrical signal to the metal conducting layer.

According to a second aspect, an electronic device is provided. The electronic device includes the display module according to the first aspect.

In embodiments of this application, the display module includes the display screen, the metal conducting layer, and the insulation protection layer. The display screen, the metal conducting layer, and the insulation protection layer are superposed sequentially. The insulation protection layer includes the at least one via. The side, of the insulation protection layer, facing away from the metal conducting layer is disposed with the at least one deformable member, and the deformable member is electrically connected to the metal conducting layer through the via. When pressure is put on the display screen, the deformable member is deformed and outputs the electrical signal to the metal conducting layer. In embodiments of this application, a pressure-sensitive module set may be combined with a display screen, so that an overall thickness can be reduced, to reduce a thickness of the electronic device, thereby further improving user experience.

**BRIEF DESCRIPTION OF DRAWINGS**

The accompanying drawings described herein are intended to provide a further understanding of this application, and constitute a part of this application. The illustrative embodiments of this application and descriptions thereof are intended to describe this application, and do not constitute limitations on this application. In the accompanying drawings:

FIG. 1 is a schematic diagram of a structure of a display module according to an example of this application not forming part of the invention;

FIG. 2 is a schematic diagram of a structure of another display module according to an example of this application not forming part of the invention;

FIG. 3 is a schematic diagram of a structure of another display module according to an example of this application not forming part of the invention;

FIG. 4 is a schematic diagram of a structure of another display module according to an example of this application not forming part of the invention;

FIG. 5 is a schematic diagram of a structure of another display module according to an example of this application not forming part of the invention;

FIG. 6 is a schematic diagram of positions of four deformable members according to an embodiment of this application;

FIG. 7 is a schematic diagram of a sensing principle according to an embodiment of this application; and

FIG. 8 is a schematic diagram of a structure of another display module according to an embodiment of this application.

In the accompanying drawings:

10: display screen;
111: display layer, and 112: insulation substrate layer;
121: display layer;
131: display layer, 132: metal grounding layer, 133: insulation substrate layer, and 1331: grounding via;
20: metal conducting layer;
211: ITO wiring layer;
30: insulation protection layer;
311: insulation substrate layer, and 301: via; and
40: deformable member.

**DESCRIPTION OF EMBODIMENTS**

The following clearly and completely describes technical solutions in embodiments of this application with reference to the accompanying drawings in embodiments of this application. Clearly, the described embodiments are some but not all of embodiments of this application. All other embodiments obtained by a person of ordinary skill in the art based on embodiments of this application without creative efforts shall fall within the protection scope of this application.

The terms "first", "second", and the like in the description and the claims of this application are used to distinguish between similar objects instead of describing a specific order or sequence. It should be understood that the data used in such a way is interchangeable in proper circumstances so that embodiments of this application can be implemented in an order other than the order illustrated or described herein. In addition, in the description and the claims, "and/or" represents at least one of connected objects, and a character "/" generally represents an "or" relationship between associated objects.

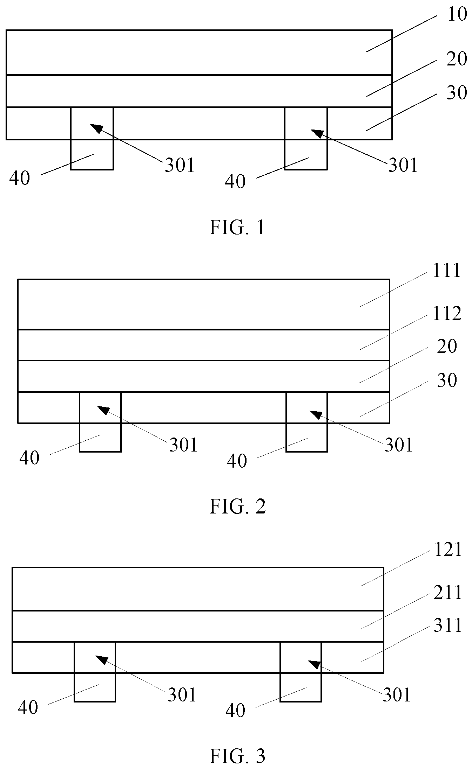

With reference to FIG. 1 to FIG. 7, an electronic device provided in embodiments of this application is described in detail by using specific embodiments and application scenarios of the embodiments.

As shown in FIG. 1, a display module may include a display screen 10, a metal conducting layer 20, and an insulation protection layer 30.

Specifically, the display screen 10, the metal conducting layer 20, and the insulation protection layer 30 are superposed sequentially. The insulation protection layer 30 includes at least one via 301. A side, of the insulation protection layer 30, facing away from the metal conducting layer 20 is disposed with at least one deformable member 40, and the deformable member 40 is electrically connected to the metal conducting layer 20 through the via 301. When pressure is put on the display screen, the deformable member 40 is deformed and outputs an electrical signal to the metal conducting layer 20.

The deformable member 40 may be a resistor, or may be piezoelectric ceramics or the like. There may be one, two, or more deformable members 40. This is not specifically limited in this example of this application not forming part of the invention. When there are a plurality of deformable members 40, distribution positions of the deformable members are not limited and are subject to an actual condition.

Optionally, a display side of the display screen 10 has a target area. When pressure is put on the target area, a pressure-sensitive module set may be deformed. There may be one, two, or more target areas. This is not specifically limited in this example of this application not forming part of the invention and is subject to an actual condition.

The metal conducting layer 20 may be a coating on the display screen 10, may be stuck to the display screen 10, or the like. The insulation protection layer 30 may be a coating disposed on a side, of the metal conducting layer 20, facing away from the display screen 10, or may be stuck to the metal conducting layer 20. The via 301 may be filled with a conducting material, for example, a metal material or a graphite material. A quantity and position of the via 301 may be determined based on a quantity and position of the deformable member 40. Specifically, the quantity of the via 301 may be equal to the quantity of the deformable member 40.

It should be noted that, in addition to the foregoing components, the display module provided in this example of this application not forming part of the invention, may further include an upper polarizing layer, a glass substrate layer, a filter layer, a lower polarizing layer, a luminescent layer, and the like. This is not described in detail in this example of this application not forming part of the invention. Different display modules may include different structures.

In this example of this application not forming part of the invention, the display module may include the display screen 10, the metal conducting layer 20, and the insulation protection layer 30. The display screen 10, the metal conducting layer 20, and the insulation protection layer 30 are superposed sequentially. The insulation protection layer 30 includes the at least one via 301. The side, of the insulation protection layer 30, facing away from the metal conducting layer 20 is disposed with the at least one deformable member 40, and the deformable member 40 is electrically connected to the metal conducting layer 20 through the via 301. When pressure is put on the display screen 10, the deformable member 40 is deformed and outputs the electrical signal to the metal conducting layer 20. In this example of this application not forming part of the invention, a pressure-sensitive module set may be formed under the screen by using the metal conducting layer 20, the insulation protection layer 30, and the deformable member 40 that are disposed on a side, of the display screen 10, facing away from a display surface, and deformation of the deformable member 40 can generate the electrical signal indicating pressure. Optionally, a greater magnitude of deformation of the deformable member 40 indicates a larger electrical signal that is output, and indicates greater pressure that the display screen has taken. As a size of the display screen 10 is large, more control modes can be implemented, and more requirements of a user for human-machine interaction can be satisfied, thereby improving user experience. The pressure-sensitive module set is combined with the display screen 10, so that an overall thickness can be reduced, to reduce a thickness of the electronic device, thereby further improving user experience.

As shown in FIG. 2, in a possible implementation of this application, the display screen 10 may include a display layer 111 and an insulation substrate layer 112.

Specifically, the insulation substrate layer 112 is disposed on a side, of the metal conducting layer 20, facing away from the insulation protection layer 30, and the display layer 111 is disposed on a side, of the insulation substrate layer 112, facing away from the metal conducting layer 20.

To be specific, the metal conducting layer 20, the insulation protection layer 30, and the deformable member 40 may form a pressure-sensitive module set, and the pressure-sensitive module set and the display layer 111 of the display screen 10 are insulated by using the insulation substrate layer 112 of the display screen 10. In this way, the pressure-sensitive module set and the display layer 111 are combined, and the pressure-sensitive module set is formed under the screen, so that a plurality of types of pressure-sensitive control can be implemented, to satisfy a plurality of requirements of a user.

As shown in FIG. 3, in a possible implementation of this application, the display module is an organic light-emitting diode (Organic Light-Emitting Diode, OLED).

Correspondingly, the display screen 10 includes a display layer 121. The metal conducting layer 20 is an indium tin oxide (Indium Tin Oxide, ITO) wiring layer of the organic light-emitting diode module, the insulation protection layer 30 is an insulation substrate layer 311 of the organic light-emitting diode module; and when pressure is put on the display screen, the deformable member 40 is deformed and outputs a pressure signal to the ITO wiring layer 211.

To be specific, when the display module is the OLED screen, the ITO wiring layer 211 of the OLED screen may replace the metal conducting layer 20 of the pressure-sensitive module set, and the insulation substrate layer 311 of the OLED screen may replace the insulation protection layer 30 of the pressure-sensitive module set.

In this example of this application not forming part of the invention, the metal conducting layer 20 and the insulation protection layer 30 of the pressure-sensitive module set may be replaced with the structures in the OLED screen, to further reduce a thickness of the pressure-sensitive module set, thereby providing better user experience.

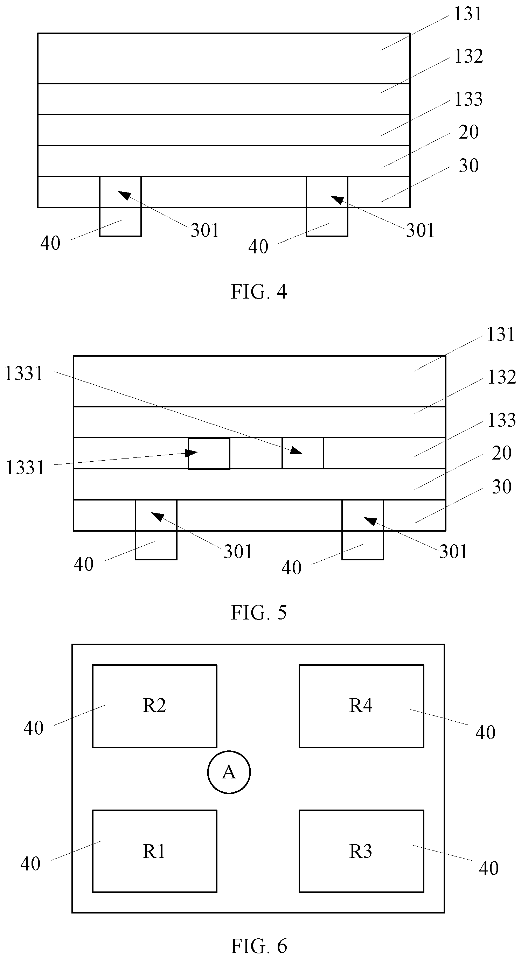

As shown in FIG. 4, in a possible implementation of this application, the display module is a liquid crystal display (Liquid Crystal Display, LCD) module.

Correspondingly, the display screen 10 includes a display layer 131, a metal grounding layer 132, and an insulation substrate layer 133. The insulation substrate layer 133 is disposed on a side, of the metal conducting layer 20, facing away from the insulation protection layer 30, the metal grounding layer 132 is disposed on a side, of the insulation substrate layer 133, facing away from the metal conducting layer 20, and the display layer 131 is disposed on a side, of the metal grounding layer 132, facing away from the insulation substrate layer 133.

To be specific, when the display module is the LCD screen, the metal grounding layer 132 of the LCD screen, that is, a metal housing of an in-cell screen, and the metal conducting layer 20 of the pressure-sensitive module set may be insulated by using the insulation substrate layer 133 of the LCD screen. In this way, the pressure-sensitive module set and the display layer are combined, and the pressure-sensitive module set is formed under the in-cell screen, so that a plurality of types of pressure-sensitive control can be implemented, to satisfy a plurality of requirements of a user and reduce a thickness of the pressure-sensitive module set.

In addition to the foregoing structures, the LCD screen may further include a backlight, a light guide film, a polarizer, a liquid crystal layer, and another structure. Specifically, when the display module is the in-cell screen, there is a metal housing, that is, a metal housing of the in-cell screen, on a side, of a light guide film, facing away from a display surface, as a reference ground for a touchscreen or the like.

Further, as shown in FIG. 5, the insulation substrate layer may be disposed with at least one grounding via 1331, and the metal conducting layer 20 is electrically connected to the metal grounding layer 132 through the grounding via 1331.

To be specific, when the display module is the LCD screen, the insulation substrate layer 133 may be disposed with the grounding via 1331, so that the metal grounding layer 132 may be used as a reference ground for the pressure-sensitive module set, to improve an anti-interference capability of the pressure-sensitive module set and also improve sensitivity for minor deformation of the deformable member 40, thereby improving detection sensitivity of the pressure-sensitive module set.

The grounding via 1331 may be filled with a conducting material, for example, a metal material or a graphite material. A quantity and position of the grounding via 1331 is not specifically limited in this application and may be determined based on an actual condition.

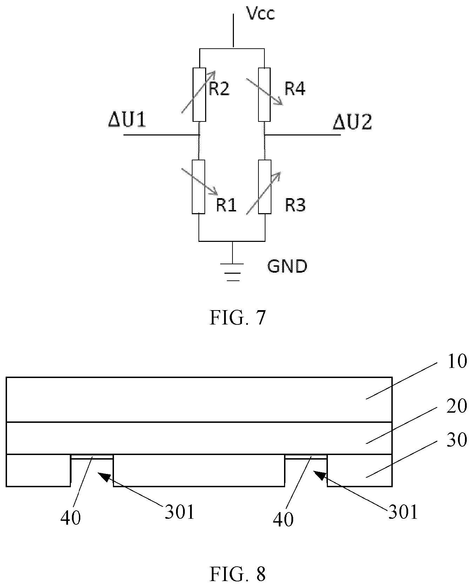

As shown in FIG. 8, in a possible implementation of this application, the deformable member 40 may be disposed inside the via 301 in the insulation protection layer 30, and the deformable member 40 is directly electrically connected to the metal conducting layer 20.

Specifically, the deformable member 40 may be added over the metal conducting layer 20 by plating. When pressure is put on the display screen, the pressure is transferred to the deformable member through various layers, to deform the deformable member. The deformation of the deformable member 40 generates a corresponding electrical signal indicating pressure. As the deformable member 40 is inside the via 301, an overall thickness in a direction perpendicular to the display screen can be reduced, to reduce a thickness of the electronic device, thereby further improving user experience.

In another embodiment, the via may be a metal via, and the deformable member 40 is added on a wall of the metal via by plating. When pressure is put on the display screen, the pressure is transferred to the insulation protection layer through various layers, and the insulation protection layer is deformed to deform the deformable member, so that the corresponding electrical signal indicating pressure is generated.

In another example not forming part of the invention, the deformable member 40 may alternatively be disposed in the metal conducting layer 20 by sticking. A length of the deformable member 40 in the direction perpendicular to the display screen 10 may be greater than a thickness of the insulation protection layer 30 in the direction perpendicular to the display screen 10. When pressure is put on the display screen, a part of the deformable member 40 outside the via 301 takes pressure, and the electrical signal is transferred to the metal conducting layer 20. The length of the deformable member 40 in the direction perpendicular to the display screen 10 may alternatively be less than the thickness of the insulation protection layer 30 in the direction perpendicular to the display screen 10. When pressure is put on the display screen, the pressure is transferred to the deformable member through various layers, to deform the deformable member, so that the corresponding electrical signal indicating pressure is generated.

In a possible implementation of this application, the via 301 in the insulation protection layer 30 may be filled with a conducting material, for example, a metal material or a graphite material. A quantity and position of the via 301 may be determined based on a quantity and position of the deformable member 40.

The deformable member 40 may be electrically connected to the metal conducting layer 20 by using the conducting material, and the deformable member 40 is completely outside the via 301. When pressure is put on the display screen, the whole deformable member is deformed, and the electrical signal is transferred to the conducting layer 20 by using the filled material. As the whole deformable member takes pressure and is deformed, measurement can be more accurate.

Further, a projection of the deformable member 40 is at least partially within a projection of the via 301 in the direction perpendicular to the display screen 10.

To be specific, the deformable member 40 may be electrically connected to the metal conducting layer 20 by using the conducting material filled in the via 301. In this way, a signal of the electrical connection can be more stable. When pressure is put on the display screen, the pressure can be better transferred to the deformable member 40, so that measurement can be more accurate.

In a possible implementation of this application, as shown in FIG. 6, there may be four deformable members 40, and correspondingly, there may also be four vias 301. The four deformable members 40 can form a Wheatstone bridge.

In this embodiment of this application, by using the plurality of deformable members 40, sensing of a pressure value can be more accurate, and a pressure change after minor deformation can be sensed.

Optionally, there may be a plurality of deformable members 40. When pressure is put on the target area, four deformable members 40 that are closest to a pressure trigger point and that have greatest magnitude of deformation may be selected from the plurality of deformable members 40 to form a Wheatstone bridge.

Because of deformation of the target area, each of the deformable members 40 is deformed, with differences in magnitude of deformation and direction. When pressure is transferred to the deformable member 40 through the metal conducting layer and the via from above to below in the direction perpendicular to the display screen 10, deformable members 40 at different positions have different magnitudes of deformation because of uneven pressure, and different voltage variables are generated. A magnitude of a voltage variable depends on a distance between the deformable member and a position of a pressure trigger point A. A shorter distance from the pressure trigger point indicates a greater magnitude of deformation, and a pressure value deceases from the pressure trigger point roughly circularly from an inner side to an outer side. In this case, the pressure value may be calculated based on a voltage change value converted from a magnitude of deformation of the deformable member 40.

For example, as shown in FIG. 6 and FIG. 7, GND means grounding. The four deformable members 40 that form the Wheatstone bridge are four resistors R1, R2, R3, and R4. A voltage change of the Wheatstone bridge is as shown in the following formula. The voltage change value, that is, an output signal, may be calculated according to the following formula, and then converted into the pressure value.

$$\Delta U1 = \frac{V_{cc} * (R1 + \Delta R_1)}{R1 + R2 + \Delta R_1 + \Delta R_2}$$

$$\Delta U2 = \frac{V_{cc} * (R3 + \Delta R_3)}{R3 + R4 + \Delta R_3 + \Delta R_4}$$

$$\Delta U = \Delta U1 - \Delta U2$$

$V_{cc}$ is a power supply voltage; R1 is a resistance value of the first resistor R1; $\Delta R_1$ is a resistance change after the first resistor R1 has deformation; R2 is a resistance value of the second resistor R2; $\Delta R_2$ is a resistance change after the second resistor R2 has deformation; R3 is a resistance value of the third resistor R3; $\Delta R_3$ is a resistance change after the third resistor R3 has deformation; R4 is a resistance value of the fourth resistor R4; $\Delta R_4$ is a resistance change after the fourth resistor R4 has deformation; $\Delta U1$ is a voltage difference between R1 and R2; $\Delta U2$ is a voltage difference between R3 and R4; and $\Delta U$ is the output signal.

In a possible implementation of this application, the metal conducting layer 20 may be plating on the display screen 10.

To be specific, the metal conducting layer 20 may be metal plating on the display screen 10.

Optionally, an embodiment of this application further provides an electronic device, including the display module provided in any one of the foregoing embodiments. The electronic device may implement any function of the display module. This is not specifically limited in this embodiment of this application.

The electronic device in this application may be a full-screen mobile phone, a tablet computer, or another device. Details are not described in this application and are subject to an actual condition.

It should be noted that, in this specification, the term "include", "comprise", or any other variant thereof is intended to cover a non-exclusive inclusion, so that a process, a method, an article, or an apparatus that includes a list of elements not only includes those elements but also includes other elements which are not expressly listed, or further includes elements inherent to such process, method, article, or apparatus. In absence of more constraints, an element preceded by "includes a..." does not preclude the existence of other identical elements in the process, method, article, or apparatus that includes the element. Furthermore, it should be noted that the scope of the methods and apparatuses in the implementations of this application is not limited to performing the functions in the order shown or discussed, but may also include performing the functions in a substantially simultaneous manner or in a reverse order depending on the functions involved. For example, the described methods may be performed in an order different from that described, and various steps may be added, omitted, or combined. In addition, features described with reference to some examples may be combined in other examples.

According to the descriptions of the foregoing implementations, a person skilled in the art may clearly understand that the foregoing method embodiments may be implemented by using software and a required universal hardware platform, or certainly may be implemented by using hardware. However, in many cases, the former is a better implementation. Based on such an understanding, the technical solutions of this application essentially or the part contributing to the prior art may be implemented in a form of a software product. The computer software product is stored in a storage medium (such as a ROM/RAM, a hard disk, or an optical disc), and includes several instructions for instructing a terminal (that may be a mobile phone, a computer, a server, an air conditioner, a network device, or the like) to perform the methods described in embodiments of this application.

**Claims**

1.　A display module, comprising a display screen (10), a metal conducting layer (20), and an insulation protection layer (30), wherein the display screen (10), the metal conducting layer (20), and the insulation protection layer (30) are superposed sequentially;

　　　the insulation protection layer (30) comprises at least one via (301);
　　　**characterized in that**,
　　　at least one deformable member (40) is disposed inside the via (301) in the insulation protection layer (30), and the deformable member (40) is directly electrically connected to the metal conducting layer (20); and
　　　when pressure is put on the display screen (10), the deformable member (40) is deformed and outputs an electrical signal to the metal conducting layer (20).

2.　The display module according to claim 1, wherein the display screen (10) comprises a display layer (111) and an insulation substrate layer (112); and
　　　the insulation substrate layer (112) is disposed on a side, of the metal conducting layer (20), facing away from the insulation protection layer (30), and the display layer (111) is disposed on a side, of the insulation substrate layer (112), facing away from the metal conducting layer (20).

3.　The display module according to claim 1, wherein the display module is an organic light-emitting diode module;

　　　the display screen (10) comprises a display layer (121);
　　　the metal conducting layer (20) is an ITO wiring layer (211) of the organic light-emitting diode module;
　　　the insulation protection layer (30) is an insulation substrate layer (311) of the organic light-emitting diode module; and
　　　when pressure is put on the display screen (10), the deformable member (40) is deformed and outputs a pressure signal to the ITO wiring layer (211).

4.　The display module according to claim 1, wherein the display module is a liquid crystal display module; and the display screen (10) comprises a display layer (131), a metal grounding layer (132), and an insulation substrate layer (133), the insulation substrate layer (133) is disposed on a side, of the metal conducting layer (20), facing away from the insulation protection layer (30), the metal grounding layer (132) is disposed on a side, of the insulation substrate layer (133), facing away from the metal conducting layer (20), and the display layer (131) is disposed on a side, of the metal grounding layer (132), facing away from the insulation substrate layer (133).

5.　The display module according to claim 4, wherein the insulation substrate layer (133) is disposed with at least one grounding via (1331), and the metal conducting layer (20) is electrically connected to the metal grounding layer (132) through the grounding via (1331).

6.　The display module according to claim 1, wherein there are four deformable members (40), there are four vias (301), and the four deformable members (40) form a Wheatstone bridge.

7.　The display module according to claim 1, wherein the metal conducting layer (20) is plating on the display screen (10).

8.　An electronic device, **characterized by** comprising the display module according to any one of claims 1 to 7.

**Patentansprüche**

1.　Anzeigemodul, umfassend einen Anzeigebildschirm (10), eine leitende Metallschicht (20) und eine Isolationsschutzschicht (30), wobei der Anzeigebildschirm (10), die leitende Metallschicht (20) und die Isolationsschutzschicht (30) nacheinander übereinander angeordnet sind;

die Isolationsschutzschicht (30) mindestens eine Durchkontaktierung (301) umfasst; **dadurch gekennzeichnet, dass** mindestens ein verformbares Element (40) innerhalb der Durchkontaktierung (301) in der Isolationsschutzschicht (30) angeordnet ist und das verformbare Element (40) direkt elektrisch mit der leitenden Metallschicht (20) verbunden ist; und wenn Druck auf den Anzeigebildschirm (10) ausgeübt wird, wird das verformbare Element (40) verformt und gibt ein elektrisches Signal an die leitende Metallschicht (20) aus.

2. Anzeigemodul nach Anspruch 1, wobei der Anzeigebildschirm (10) eine Anzeigeschicht (111) und eine Isolationssubstratschicht (112) umfasst; und die Isolationssubstratschicht (112) auf einer der Isolationsschutzschicht (30) abgewandten Seite der leitenden Metallschicht (20) angeordnet ist und die Anzeigeschicht (111) auf einer der leitenden Metallschicht (20) abgewandten Seite der Isolationssubstratschicht (112) angeordnet ist.

3. Anzeigemodul nach Anspruch 1, wobei das Anzeigemodul ein organisches Leuchtdiodenmodul ist;

der Anzeigebildschirm (10) eine Anzeigeschicht (121) umfasst; die leitende Metallschicht (20) eine ITO-Verdrahtungsschicht (211) des organischen Leuchtdiodenmoduls ist; die Isolationsschutzschicht (30) eine Isolationssubstratschicht (311) des organischen Leuchtdiodenmoduls ist; und wenn Druck auf den Anzeigebildschirm (10) ausgeübt wird, wird das verformbare Element (40) verformt und gibt ein Drucksignal an die ITO-Verdrahtungsschicht (211) aus.

4. Anzeigemodul nach Anspruch 1, wobei das Anzeigemodul ein Flüssigkristallanzeigemodul ist; und der Anzeigebildschirm (10) eine Anzeigeschicht (131), eine Metallerdungsschicht (132) und eine Isolationssubstratschicht (133) umfasst, die Isolationssubstratschicht (133) auf einer von der Isolationsschutzschicht (30) abgewandten Seite der leitenden Metallschicht (20) angeordnet ist, die Metallerdungsschicht (132) auf einer von der leitenden Metallschicht (20) abgewandten Seite der Isolationssubstratschicht (133) angeordnet ist und die Anzeigeschicht (131) auf einer von der Isolationssubstratschicht (133) abgewandten Seite der Metallerdungsschicht (132) angeordnet ist.

5. Anzeigemodul nach Anspruch 4, wobei die Isolationssubstratschicht (133) mit mindestens einer Erdungsdurchkontaktierung (1331) angeordnet ist und die leitende Metallschicht (20) durch die Erdungsdurchkontaktierung (1331) elektrisch mit der Metallerdungsschicht (132) verbunden ist.

6. Anzeigemodul nach Anspruch 1, wobei vier verformbare Elemente (40) vorhanden sind, vier Durchkontaktierungen (301) vorhanden sind und die vier verformbaren Elemente (40) eine Wheatstone-Brücke bilden.

7. Anzeigemodul nach Anspruch 1, wobei die leitende Metallschicht (20) auf dem Anzeigebildschirm (10) plattiert ist.

8. Elektronische Vorrichtung, **dadurch gekennzeichnet, dass** sie das Anzeigemodul nach einem der Ansprüche 1 bis 7 umfasst.

## Revendications

1. Module d'affichage, comprenant un écran d'affichage (10), une couche conductrice métallique (20) et une couche de protection isolante (30), dans lequel l'écran d'affichage (10), la couche conductrice métallique (20) et la couche de protection isolante (30) sont superposés séquentiellement ;

la couche de protection isolante (30) comprend au moins un trou d'interconnexion (301) ; **caractérisé en ce que**, au moins un élément déformable (40) est disposé à l'intérieur du trou d'interconnexion (301) dans la couche de protection isolante (30), et l'élément déformable (40) est directement connecté électriquement à la couche conductrice métallique (20) ; et lorsqu'une pression est exercée sur l'écran d'affichage (10), l'élément déformable (40) se déforme et émet un signal électrique vers la couche conductrice métallique (20).

2. Module d'affichage selon la revendication 1, dans lequel l'écran d'affichage (10) comprend une couche d'affichage (111) et une couche de substrat isolante (112) ; et la couche de substrat isolante (112) est disposée sur un côté, de la couche conductrice métallique (20), opposé à la couche de protection isolante (30), et la couche d'affichage (111) est disposée sur un côté, de la couche de substrat isolante (112), opposé à la couche conductrice métallique (20).

3. Module d'affichage selon la revendication 1, dans lequel le module d'affichage est un module de diodes électroluminescentes organiques ;

l'écran d'affichage (10) comprend une couche d'affichage (121) ;
la couche conductrice métallique (20) est une couche de câblage d'ITO (211) du module de diodes électroluminescentes organiques ;
la couche de protection isolante (30) est une couche de substrat isolante (311) du module de diodes électroluminescentes organiques ; et
lorsqu'une pression est exercée sur l'écran d'affichage (10), l'élément déformable (40) se déforme et émet un signal de pression à la couche de câblage d'ITO (211).

4. Module d'affichage selon la revendication 1, dans lequel le module d'affichage est un module d'affichage à cristaux liquides ; et
l'écran d'affichage (10) comprend une couche d'affichage (131), une couche de mise à la terre métallique (132) et une couche de substrat isolante (133), la couche de substrat isolante (133) est disposée sur un côté, de la couche conductrice métallique (20), opposé à la couche de protection isolante (30), la couche de mise à la terre métallique (132) est disposée sur un côté, de la couche de substrat isolante (133), opposé à la couche conductrice métallique (20), et la couche d'affichage (131) est disposée sur un côté, de la couche de mise à la terre métallique (132), opposé à la couche de substrat isolante (133).

5. Module d'affichage selon la revendication 4, dans lequel la couche de substrat isolante (133) est disposée avec au moins un trou d'interconnexion de mise à la terre (1331), et la couche conductrice métallique (20) est connectée électriquement à la couche de mise à la terre métallique (132) par l'intermédiaire du trou d'interconnexion de mise à la terre (1331).

6. Module d'affichage selon la revendication 1, dans lequel se trouvent quatre éléments déformables (40), se trouvent quatre trous d'interconnexion (301), et les quatre éléments déformables (40) forment un pont de Wheatstone.

7. Module d'affichage selon la revendication 1, dans lequel la couche conductrice métallique (20) est plaquée sur l'écran d'affichage (10).

8. Dispositif électronique, **caractérisé en ce qu'**il comprend le module d'affichage selon l'une quelconque des revendications 1 à 7.

FIG. 1

FIG. 2

FIG. 3

FIG. 4

FIG. 5

FIG. 6

Vcc

R2　R4

ΔU1　　ΔU2

R1　R3

GND

FIG. 7

10
20
30

40　301　40　301

FIG. 8

**EP 4 343 504 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 107340929 A
- EP 3327556 A1
- EP 0706147 A2
- EP 2267791 A2
- US 9880676 B1
- US 2019121484 A1
- CN 102236447 A